# EUROPEAN PATENT SPECIFICATION

(11) **EP 0 720 294 B1**
(45) Date of publication and mention of the grant of the patent: **25.03.1998**
(21) Application number: 94830594.1
(22) Date of filing: 30.12.1994
(51) Int. Cl.: H03K 19/003, H03K 19/0185

(54) **Interface circuit for electronic devices monolitically integrated on semiconductor by MOS/CMOS technology**
Schnittstellenschaltung für auf einem Halbleiter in MOS/CMOS-Technologie monolithisch integrierte elektronische Einrichtungen
Circuit d'interface pour dispositifs électroniques intégrés monolithiquement sur un semi-conducteur par la technologie MOS/CMOS

(43) Date of publication of application: 03.07.1996
(73) Proprietor: SGS-THOMSON MICROELECTRONICS s.r.l., 20041 Agrate Brianza (Milano) (IT)
(72) Inventor: Benedetti, Mirella, I-20059 Vimercate (Milano) (IT)
(74) Representative: Botti, Mario

(56) References cited:
- US-A- 5 319 259

## Description

This invention relates to an interface circuit for driving the input stage of electronic devices monolithically integrated on a semiconductor in technology of the MOS/CMOS type.

These devices can be implemented by a variety of logic structures, such as a Schmitt trigger, a NOR or NAND logic gate, or an inverter.

All these devices receive an input signal which is applied to a thin gate oxide.

As is well known, in order to optimize the performance of integrated devices, especially in terms of size, power consumption, and speed of operation, increasingly more sophisticated technologies are employed, wherein a reduction in the horizontal and vertical dimensions of the semiconductor integrated devices is accompanied by a reduction in the supply voltages thereto.

In particular, diminished supply voltages, and hence amplitudes of the signals involved, can improve the electric performance of the above devices; in fact, this reduction both results in less dissipated power and faster transitions between logic states. Lower supply voltages also allow problems tied to the reliability aspect to be solved. The presence of electric fields within the integrated devices, due to voltages which may be too high for the available geometries, can be a cause of abnormal dissipations, as well as of current losses and transistor gate oxide breakdowns.

This unavoidably results in shortened useful life of the integrated device.

It can be appreciated from the above considerations that any integration process would be dependent on design rules which determine both its dimensional and electrical limitations. Specifically, design rules set limitations not only for the device growth step but its application field as well.

In addition, the integrated devices in question may not be used in an applicational context technologically homogeneous.

This involves interconnection of devices which are supplied different voltages, and hence, poses a variety of important problems connected with their interfacing.

One of these problems is represented by the instance of an input stage of an integrated device having to be driven by signals with greater amplitudes than the limit voltage applicable thereto.

This may cause extensive damage, especially because of the high value of the voltages present between the gate and drain terminals, or between the gate and source terminals, of the MOS and CMOS transistors included in the device.

To obviate this drawback, interface circuits have been used which are integrated on the same chip as the device.

The provision of such circuits allows direct connections to be avoided between devices which are driven by signals with different amplitudes, as this would actually be a breach on the electric limitations dictated by the reduced thickness of the gate oxide.

It should be pointed out that, in general, the principal characteristics of a good interface circuit are the following:
- it should be supplied the same voltage as the host integrated device;
- it should safely accommodate the application of input signals of greater amplitude than the supply voltage thereto;
- the potential difference present between the gate and source terminals and the gate and drain terminals of the transistors in the circuit should never exceed the limit set by the design rules, which limit would lie just above the highest supply voltage to the integrated device; and
- it should be able to transfer, to the input of the device to be interfaced, a signal of varying amplitude from a high to a low level, so as to minimize if not cancel altogether the quiescent device power consumption.

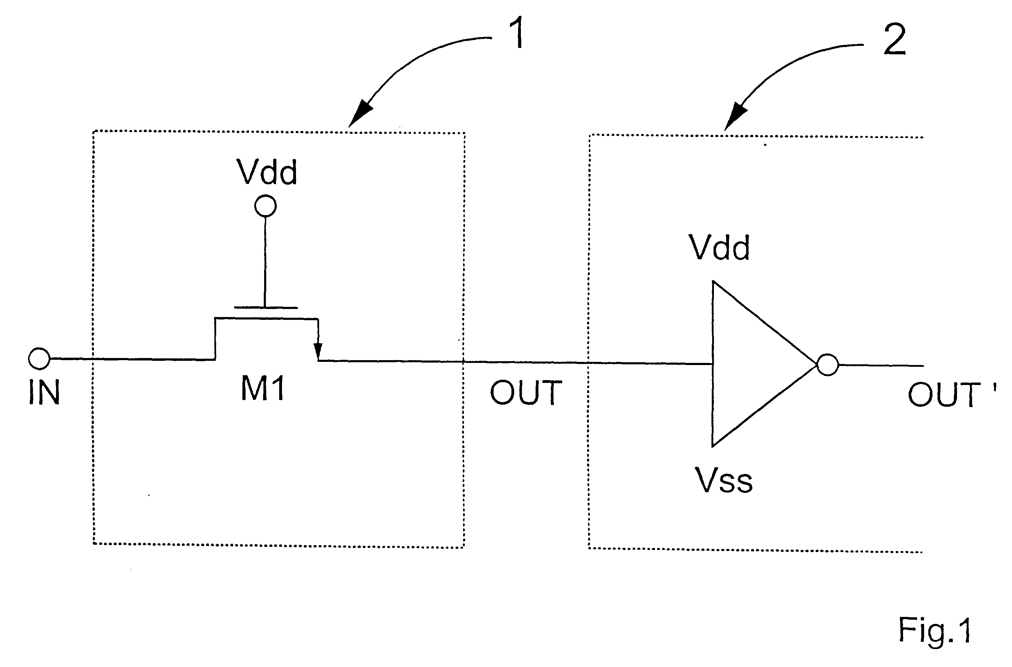

An interface circuit utilized by the prior art is shown in Figure 1.

It can be seen, from this Figure, that the- circuit, as generally shown at 1, has an input terminal IN and an output terminal OUT, between which terminals a first transistor M1, e.g. an N-channel MOS type, is connected which has first and second terminals and a control terminal.

Specifically, the first and second terminals of the transistor M1 are respectively associated with the input terminal IN and the output terminal OUT of the interface circuit 1.

The control terminal of the transistor M1 is connected to a supply voltage pole Vdd.

The interface circuit 1 operates as follows.

The transistor M1 is at all times conducting because its control terminal is connected to the voltage supply Vdd, where Vdd = 3V, for example.

This results in the voltage across the second terminal and the control terminal of the transistor M1 always having a value close to a threshold voltage VT of the transistor.

For an N-channel MOS transistor, this voltage is typically on the order of 1V.

Consequently, if the input terminal IN of the interface circuit 1 is applied, for instance, a voltage waveform Vin with 0 to 5V amplitude, the voltage Vout at the output terminal OUT of the circuit 1 will vary between 0V and a value which corresponds approximately to Vdd - VT, i.e. to about 2V with the supply voltage Vdd = 3V and the threshold voltage VT in the 1V range.

Now, if the output terminal OUT of the interface circuit 1 is connected to an input terminal of a logic structure 2, such as an inverter whose high level is coincident with the value of the supply voltage Vdd, being here 3V, since the voltage at the output terminal OUT of the interface circuit 1 is of about 2V, the inverter will never be input a sufficiently high level to ensure its proper perfomance.

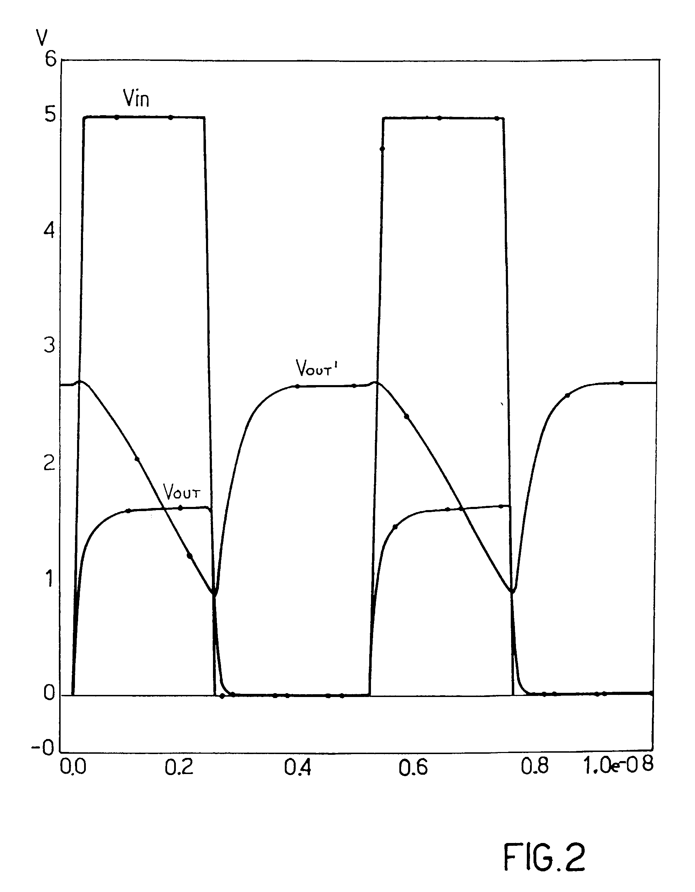

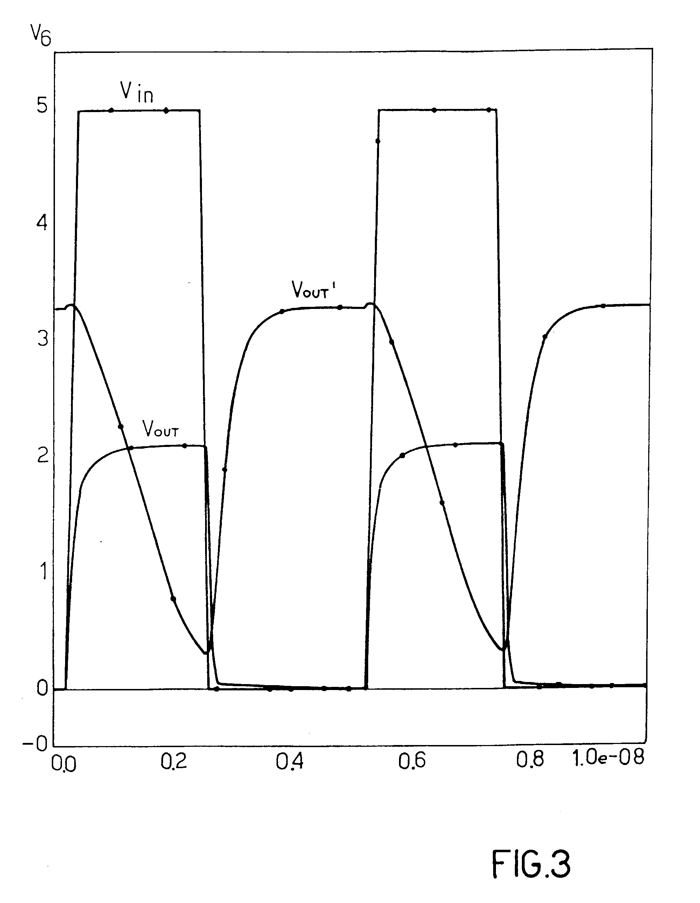

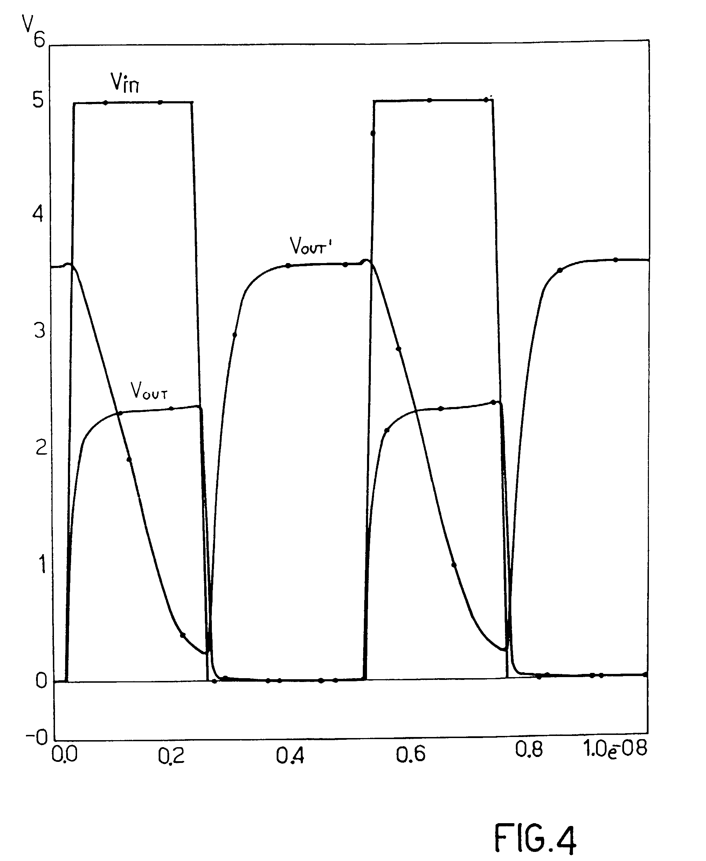

It is for this reason that, as shown in Figures 2, 3 and 4, the dynamic output response of the logic structure 2, as evaluated at different values of the supply voltage Vdd, is a very slow one.

With continued reference to Figures 2, 3 and 4, it can be seen that an undesired current (quiescent supply current) is also flowed through the logic structure 2.

The underlying technical problem of this invention is to provide an interface circuit for electronic devices monolithically integrated on a semiconductor in a technology of the MOS/CMOS type, which can drive any logic structures with a signal of greater amplitude than the highest operating voltage set by the inherent features of strength and reliability of the gate oxide, while retaining the electric performance features of said structure.

This technical problem is solved by an interface circuit for electronic devices monolithically integrated on a semiconductor in a technology of the MOS/CMOS type as defined in Claim 1 following.

The features and advantages of a circuit according to the invention will be apparent from the following description of an embodiment thereof, to be read by way of non-limitative example with reference to the accompanying drawings.

In the drawings:
Figure 1 shows a diagram of an interface circuit according to the prior art;
Figures 2, 3 and 4 illustrate the pattern, as assessed for different values of the supply voltage, of the voltages Vout and Vout', respectively present at the output of the interface circuit of Figure 1 and the output of a logic structure connected thereto;
Figure 5 shows a diagram of an interface circuit according to this invention; and
Figures 6, 7 and 8 illustrate the pattern, as assessed for different values of the supply voltage, of the voltages Vout and Vout', respectively present at the output of the interface circuit of Figure 5 and the output of a logic structure connected thereto.

With reference to the drawing figures, generally and schematically shown at 1 is an interface circuit for electronic devices monolithically integrated on a semiconductor in technologies of the MOS/CMOS type, which includes an input terminal IN and an output terminal OUT.

Connected between these two terminals is a first transistor M1, e.g. an N-channel MOS type, having first and second terminals and a control terminal.

Specifically, the first and second terminals of the transistor M1 are respectively associated with the input IN and output OUT terminals of the interface circuit 1, while its control terminal is connected to a supply voltage pole Vdd.

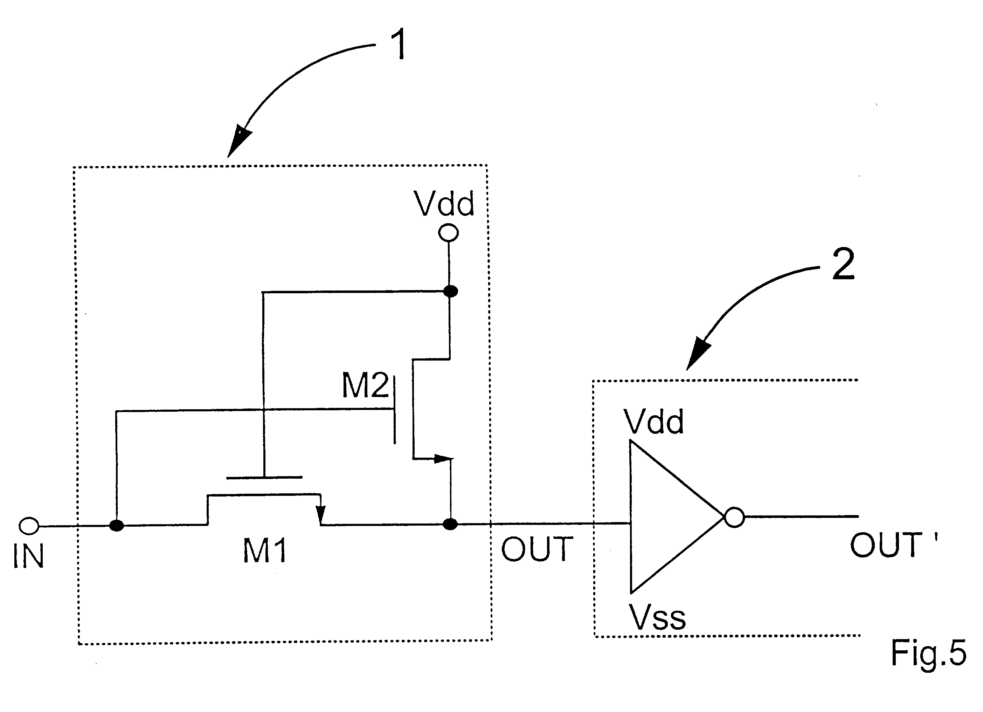

Advantageously, and as shown in Figure 5, the interface circuit 1 further comprises a second M2 transistor, which may be an N-channel MOS type, having first and second terminals and a control terminal.

In particular, the first and second terminals of the transistor M2 are respectively connected to the supply voltage pole Vdd and the output terminal OUT of the interface circuit 1, while its control terminal is connected to the input terminal IN of the interface circuit 1.

Also with reference to Figure 5, the output terminal OUT of the interface circuit 1 is connected to an input terminal of a logic structure 2, such as an inverter.

The logic structure 2 has a high level which coincides with the supply voltage Vdd, e.g. Vdd = 3V, and a low level which coincides with a voltage value denoted by Vss, e.g. Vss = 0V.

The interface circuit 1 operates as follows.

When the input terminal IN of the interface circuit 1 is applied, for example, a voltage waveform Vin with an amplitude in the 0V to 5V range, the transistor M1 only contributes to the value of the voltage Vout present at the output terminal OUT of the interface circuit 1 within a segment which varies from 0V to a corresponding value to approximately Vdd - VT, i.e. about 2V, where Vdd = 3V is the supply voltage, and VT is the threshold voltage of the transistor M1 which, for an N-channel MOS transistor, has typically a value of about 1V.

Thus, the transistor M1 basically functions to transfer, to the output terminal OUT of the interface circuit 1, the low level of the input voltage Vin which, in this case, is 0V and coincident with the low level Vss of the logic structure 2.

The transistor M2, in turn, by having its control terminal connected to the input terminal IN of the interface circuit 1, will be conducting as the input voltage Vin approaches the high level.

Since this level typically is much higher than the value Vdd + VT, where VT is the threshold voltage of the transistor M2, the voltage Vout at the output terminal OUT of the interface circuit 1 will have the value Vdd as its asymptote. Therefore, the transistor M2 functions to transfer, to the output terminal OUT of the interface circuit 1, the value Vdd being coincident with the high level of the logic structure 2.

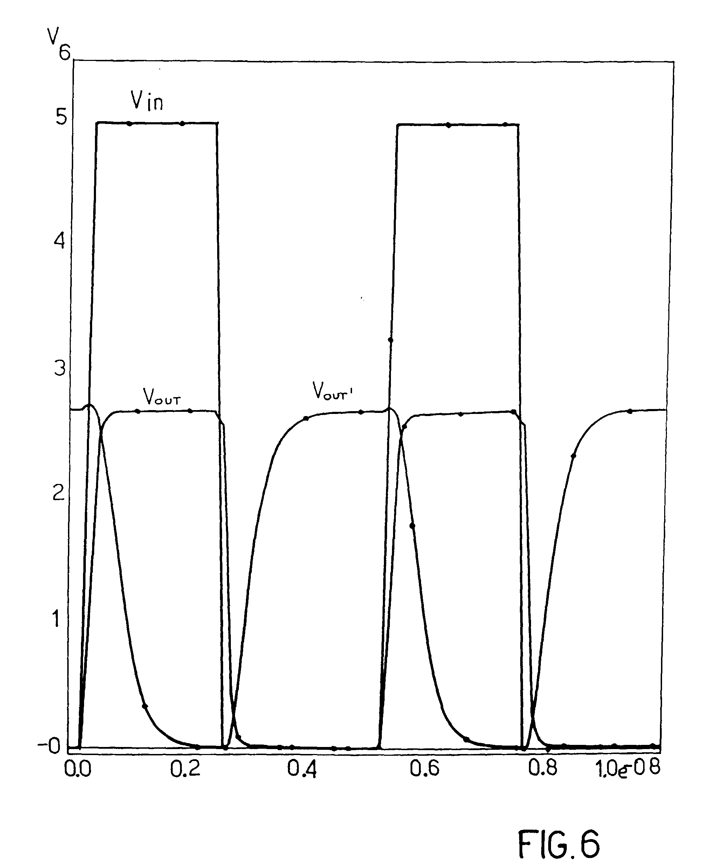

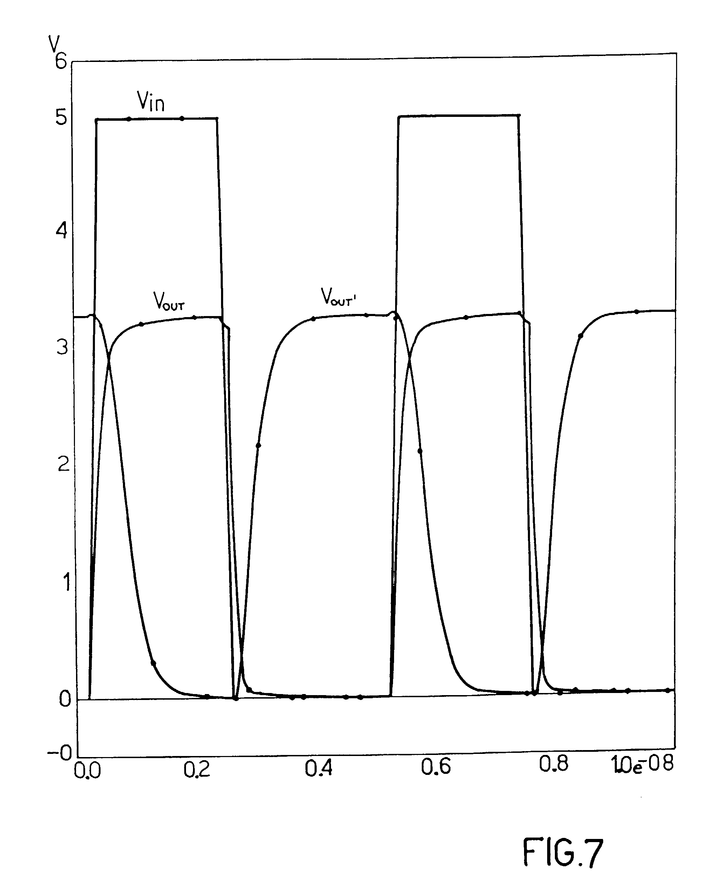

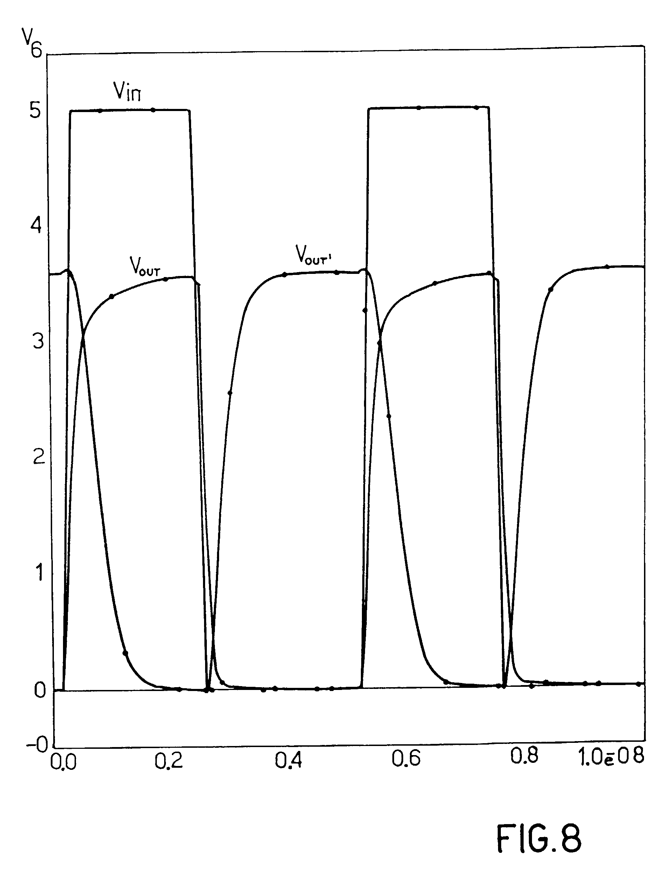

As shown in Figures 6, 7 and 8, the output voltage Vout, being calculated for different values of the supply voltage Vdd, will never exceed the foregoing values, thereby maintaining correct conditions of operation for the logic structure 2.

Also with reference to Figures 6, 7 and 8, it can be seen that, by being operated in correct conditions, the logic structure 2 will develop no fixed current draw any more.

The transistors M1 and M2 are also operated within their correct range provided that, of course, the corresponding value to Vinmax - Vddmin never exceeds the gate oxide damaging voltage, which lies close to Vddmax.

## Claims

1. An interface circuit for monolithically integrated electronic devices, including an input terminal (IN) and output terminal (OUT) with at least a first transistor (M1) connected therebetween which has first and second terminals and a control terminal, said first and second terminals being respectively associated with said input (IN) and output (OUT) terminals and said control terminal connected to a supply voltage pole (Vdd), characterized in that it comprises at least a second transistor (M2) having first and second terminals connected to said supply voltage pole (Vdd) and the output terminal (OUT) of the interface circuit (1), respectively, and a control terminal connected to the input terminal (IN) of the interface circuit (1).

2. An interface circuit according to Claim 1, characterized in that said first (M1) and second (M2) transistors are transistors of the N-channel MOS type.

3. An interface circuit according to Claim 2, characterized in that it is integrated monolithically in technologies of the kind used for implementing transistors of the MOS/CMOS type.

4. An interface circuit according to Claim 3, characterized in that the output terminal (OUT) of said circuit is arranged to drive an input stage of a logic-type structure (2).

## Patentansprüche

1. Schnittstellenschaltung für monolithisch integrierte elektronische Bauelemente, umfassend einen Eingangsanschluß (IN) und einen Ausgangsanschluß (OUT) mit mindestens einem ersten Transistor (M1), der zwischen diese Anschlüsse geschaltet ist und einen ersten sowie einen zweiten Anschluß sowie einen Steueranschluß besitzt, von denen der erste und der zweite Anschluß dem Eingangsanschluß (IN) bzw. dem Ausgangsanschluß (OUT) zugeordnet sind, während der Steueranschluß an einen Versorgungsspannungspol (Vdd) angeschlossen ist, dadurch gekennzeichnet, daß sie mindestens einen zweiten Transistor (M2) mit einem ersten und einem zweiten an den Versorgungsspannungspol (Vdd) bzw. den Ausgangsanschluß (OUT) der Schnittstellenschaltung (1) gekoppelten Anschluß und einem an den Eingangsanschluß (IN) der Schnittstellenanschluß (IN) angeschlossenen Steueranschluß enthält.

2. Schnittstellenschaltung nach Anspruch 1, dadurch gekennzeichnet, daß der erste (M1) und der zweite (M2) Transistor N-Kanal-MOS-Transistoren sind.

3. Schnittstellenschaltung nach Anspruch 2, dadurch gekennzeichnet, daß sie in der Technologie monolithisch integriert sind, die zum Implementieren von MOS/COMS-Transistoren verwendet wird.

4. Schnittstellenschaltung nach Anspruch 3, dadurch gekennzeichnet, daß der Ausgangsanschlu (OUT) der Schaltung dazu ausgelegt ist, eine Eingangsstufe einer Logik-Struktur (2) anzusteuern.

## Revendications

1. Un circuit d'interface pour des dispositifs électroniques intégrés monolithiquement, comprenant une borne d'entrée (IN), une borne de sortie (OUT) avec au moins un premier transistor (M1) connecté entre celles-ci qui comporte des première et seconde bornes et une borne de commande, lesdites première et seconde bornes étant respectivement associées avec lesdites bornes d'entrée (IN) et de sortie (OUT) et ladite borne de commande étant connectée à un pôle de tension d'alimentation (Vdd), caractérisé en ce qu'il comprend au moins un second transistor (M2) ayant des première et seconde bornes connectées audit pôle de tension d'alimentation (Vdd) et à la borne de sortie (OUT) du circuit d'interface (1), respectivement, et une borne de commande connectée à la borne d'entrée (IN) du circuit d'interface (1).

2. Un circuit d'interface selon la revendication 1, caractérisé en ce que lesdits premier et second transistors (M1 et M2) sont des transistors de type MOS à canal N.

3. Un circuit d'interface selon la revendication 2, caractérisé en ce qu'il est intégré monolithiquement selon des technologies du type de celles qui sont utilisées pour réaliser des transistors du type (MOS/CMOS).

4. Un circuit d'interface selon la revendication 3, caractérisé en ce que la borne de sortie (OUT) dudit circuit est arrangée pour piloter un étage d'entrée d'une structure de type logique (2).
